Europäisches Patentamt

European Patent Office

Office européen des brevets

(11) Veröffentlichungsnummer: **0 408 897 A2**

## (12) EUROPÄISCHE PATENTANMELDUNG

(21) Anmeldenummer: **90111280.5**

(22) Anmeldetag: **15.06.90**

(51) Int. Cl.5: **H04B 10/14**

(30) Priorität: **20.07.89 DE 3924381**

(43) Veröffentlichungstag der Anmeldung:
**23.01.91 Patentblatt 91/04**

(84) Benannte Vertragsstaaten:
**AT BE CH DE ES FR GB GR IT LI LU NL SE**

(71) Anmelder: **KRONE Aktiengesellschaft**
**Beeskowdamm 3-11**
**D-1000 Berlin 37(DE)**

(72) Erfinder: **Huynh, Hon**
**Lipschitzallee 46**
**D-1000 Berlin 47(DE)**
Erfinder: **Belohoubek, Otto**
**Schlangenbader Strasse 14**
**D-1000 Berlin 33(DE)**

(54) **Optischer Sender für elektrische Datensignale.**

(57) Die Erfindung bezieht sich auf einen optischen Sender für elektrische Datensignale, aus einer Sendediode, insbesondere Laserdiode oder lichtemittierende Diode, mit einer Vorstromquelle, aus einem zwei Emitterverstärker und eine Modulationsstromquelle umfassenden Differenzverstärker und aus einer, eine Photodiode umfassenden Detektorschaltung zur Regelung des Vorstromes und des dem elektrischen Datensignal proportionalen Modulationsstromes in Abhängigkeit von den, von der Photodiode empfangenen optischen Impulsen der Sendediode.

Mit einem bekannten optischen Sender dieser Art wird nur erreicht, daß die mittlere optische Sendeleistung (Pm) und die Amplituden (Ps) der optischen Impulse konstant gehalten werden können. Jedoch ändert sich das Tastverhältnis des optischen Sendesignales z.B. in Abhängigkeit von der Temperatur oder der Versorgungsspannung.

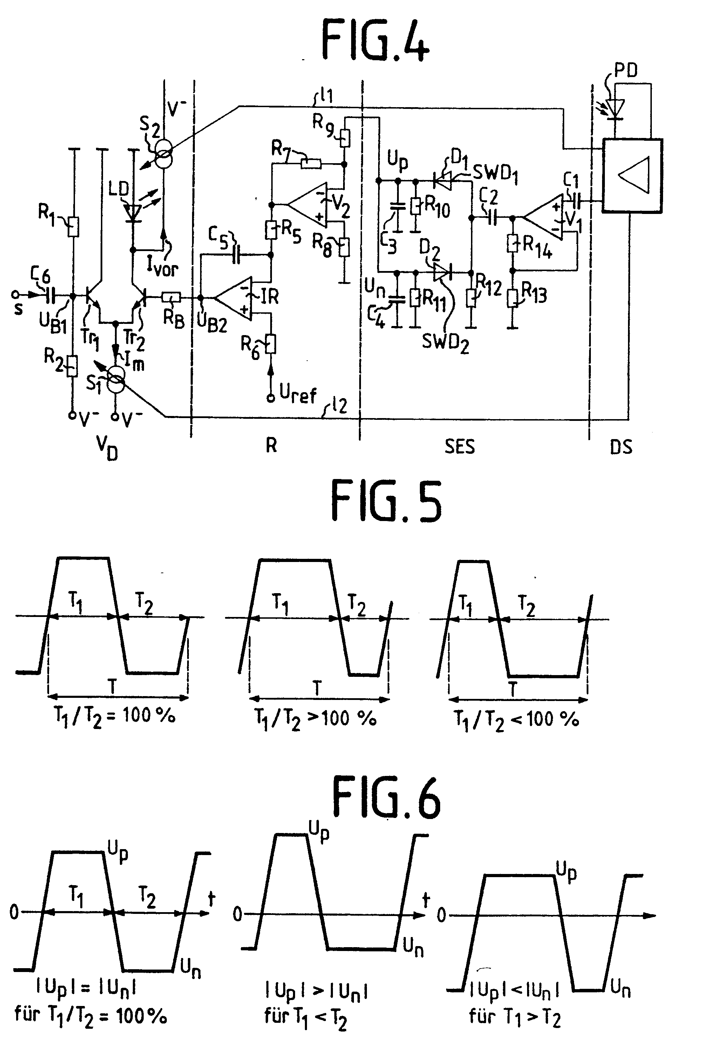

Zur Vermeidung dieser Nachteile sieht die Erfindung vor, daß zwischen die Detektorschaltung (DS) und dem Differenzverstärker ($V_D$) eine Spitzenwert-Erkennungsschaltung (SES) und ein Regler (R) eingeschaltet sind und daß das Tastverhältnis ($T_1, T_2$) des optischen Sendesignales ($S_{opt}$) der Sendediode (LD) in Abhängigkeit von den mittels der Spitzenwert-Erkennungsschaltung (SES) ermittelten Spitzenwerten ($U_p$, $U_n$) der positiven und negativen Amplituden mittels des Reglers (R) konstant gehalten werden. (FIG.4)

FIG.4

## OPTISCHER SENDER FÜR ELEKTRISCHE DATENSIGNALE

Die Erfindung bezieht sich auf einen optischen Sender für elektrische Datensignale gemäß dem Oberbegriff des Anspruches 1.

Bei einem bekannten optischen Sender der gattungsgemäßen Art wird die Sendediode, insbesondere Laserdiode oder lichtemittierende Diode, durch einen Differenzverstärker angesteuert, der aus zwei Emitterverstärkern und einer Stromquelle besteht. Der Differenzverstärker kann sehr schnell arbeiten, so daß dieser für die Übertragung von elektrischen Signalen höherer Bitrate sehr gut geeignet ist. Wenn die Transistoren der Emitterverstärker völlig identisch sind, wird der Differenzverstärker von der Umgebungstemperatur nicht beeinträchtigt, so daß der Ansteuerungsstrom für die Sendediode in der Form konstant bleibt. Ein optisches Datensignal mit einem Tastverhältnis von 1:1 erzeugt eine niedrigste Bitfehlerhäufigkeit. Diese steigt aber sehr schnell an, wenn das Tastverhältnis von diesem Idealwert abweicht, bis zu einer Grenze, bei der eine einwandfreie Nachrichtenübertragung nicht mehr möglich ist. Die Sendediode, insbesondere Laserdiode, benötigt einen Vorstrom, der etwa so groß ist wie der Schwellstrom, bei dem die Laserdiode zu lasern beginnt, und einen Modulationsstrom, der dem elektrischen Datensignal proportional ist. Wegen der starken Temperaturabhängigkeit ist es erforderlich, sowohl den Vorstrom als auch den Modulationsstrom in ihrer Größe mit Hilfe einer Photodiode und einer Detektorschaltung derart zu regeln, daß die mittlere optische Sendeleistung und die Amplituden der optischen Impulse erhalten bleiben. Außerdem ist die Regelung des Modulationsstromes deswegen erforderlich, weil die Licht-Strom-Kennlinie (PI-Kennlinie) von Laserdioden durch sogenannte Alterungseffekte normalerweise flacher wird.

Ein Differenzverstärker mit der idealen Eigenschaft benötigt zwei völlig identische Transistoren für die beiden Emitterverstärker und völlig identische Widerstände für die Einstellung des Arbeitspunktes. Nur dann können die jeweiligen Basisspannungen der beiden Transistoren und die beiden durch die Kollektorkreise fließenden Ströme gleich sein und von der Temperatur nicht beeinflußt werden. Im realen Falle sind die Spannungen jedoch wegen der unterschiedlichen Eigenschaften der Transistoren und Widerstände ungleich, so daß sich das Tastverhältnis der optischen Impulsform mit der Temperatur ändert, obwohl die mittlere Sendeleistung durch die Regelung konstant gehalten werden kann. Die Folge ist, daß die Bitfehlerhäufigkeit schwankt oder ansteigt, z.B. in Abhängigkeit von der Temperatur.

Der Erfindung liegt von daher die Aufgabe zugrunde, einen optischen Sender für elektrische Datensignale der gattungsgemäßen Art zu schaffen, bei dem das Tastverhältnis der optischen Impulsform des optischen Sendesignales konstant ist.

Die Lösung dieser Aufgabe ergibt sich aus den kennzeichnenden Merkmalen des Anspruches 1. Erfindungsgemäß werden die Ist-Werte des Tastverhältnisses detektiert, indem der Wechselanteil des optischen Sendeimpulses mittels einer Photodiode detektiert und mit Hilfe von zwei Spitzenwertdetektoren in die positive und negative Amplitude zerlegt wird. Mit Hilfe der Differenz zwischen der positiven und negativen Amplitude kann die Spannung im Arbeitspunkt über einen Regelkreis so geregelt werden, daß das Tastverhältnis des optischen Sendesignales immer einen konstanten Wert hat, z.B. 1:1. Dabei wird der Wechselanteil des mit Hilfe der Photodiode detektierten Tastsignales über einen ersten Kondensator gekoppelt. Das gekoppelte Signal wird durch einen ersten Verstärker verstärkt und durch den positiven bzw. negativen Spitzenwert-Detektor in die positive Spannung bzw. in die negative Spannung zerlegt. Die Differenz der Spannungssignale wird durch einen zweiten Verstärker verstärkt und dem einen Eingang eines I-Reglers zugeführt. Mit Hilfe einer Referenzspannung am anderen Eingang des I-Reglers wird das erwünschte Tastverhältnis eingestellt. Der Ausgang des I-Reglers wird mit der Basis des zweiten Transistors des Differenzverstärkers über einen Basiswiderstand verbunden, so daß der Regelkreis geschlossen ist.

Weitere vorteilhafte Ausgestaltungen der Erfindung ergeben sich aus den Unteransprüchen.

Die Erfindung ist nachfolgend anhand des Standes der Technik und anhand eines Ausführungsbeispieles eines optischen Senders für elektrische Datensignale näher erläutert.

Es zeigen:

Fig. 1 die bekannte Schaltungsanordnung zur Ansteuerung einer Laserdiode mittels eines Differenzverstärkers,

Fig. 2 das Blockschaltbild der erfindungsgemäßen Schaltungsanordnung des optischen Senders,

Fig. 3 den vereinfacht dargestellten Schaltungsaufbau der erfindungsgemäßen Schaltungsanordnung des optischen Senders,

Fig. 4 die konkrete erfindungsgemäße Schaltungsanordnung des optischen Senders für elektrische Datensignale und

Fig.5 und 6 verschiedene Tastverhältnisse $(T_1/T_2)$ eines Datensignales der Periodendauer $(T = T_1 + T_2)$.

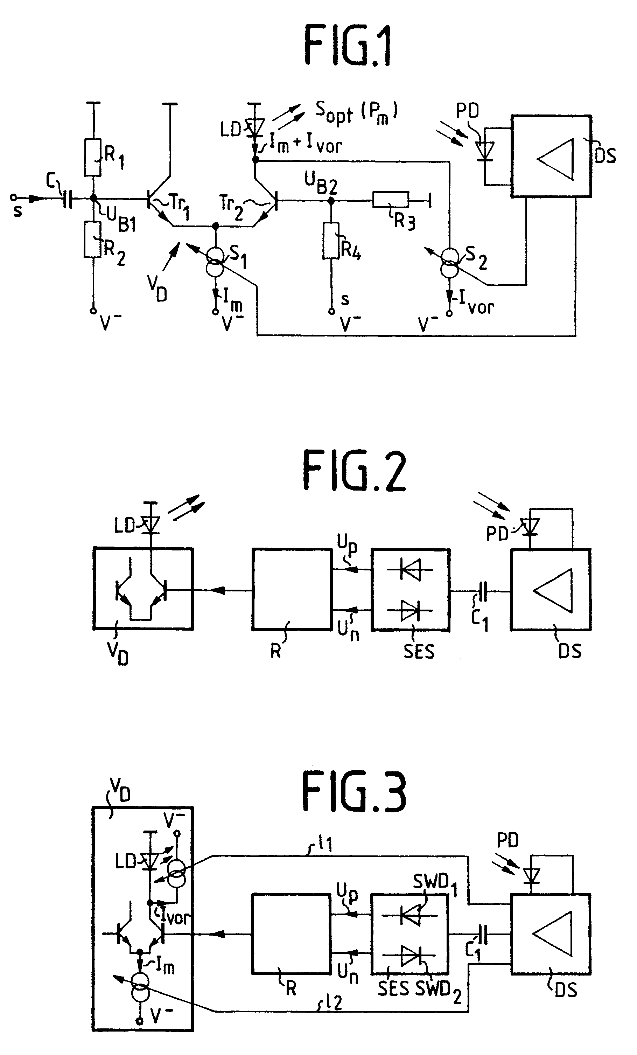

Der bekannte optische Sender für elektrische Datensignale umfaßt gemäß Fig. 1 eine Sendediode in Form einer Laserdiode LD mit einer Vorstromquelle $S_2'$, einen zwei Emitterverstärker $T_{r1}$, $T_{r2}$ und eine Modulationsstromquelle $S_1$ umfassenden Differenzverstärker $V_D$ und eine, eine Photodiode PD umfassende Detektorschaltung DS zur Regelung des Vorstromes $I_{vor}$ und des dem elektrischen Datensignal s proportionalen Modulationsstromes $I_m$ in Abhängigkeit von den, von der Photodiode PD empfangenen optischen Sendeimpulsen $S_{opt}$ der Sendediode LD. Zwei Widerstände $R_1$, $R_2$ sowie ein Kondensator C dienen zur Einstellung des Arbeitspunktes $U_{B1}$ des einen Transistors $T_{r1}$ des Differenzverstärkers $V_D$. Entsprechend dienen zwei Widerstände $R_3$, $R_4$ zur Einstellung des Arbeitspunktes $UB_2$ des weiteren Transistors $T_{r2}$ des Differenzverstärkers $V_D$.

Die Laserdiode LD des optischen Senders wird durch den Differenzverstärker $V_D$ angesteuert, welcher aus den beiden Transistoren $T_{r1}$, $T_{r2}$ der Emitterverstärker und der Stromquelle $S_1$ besteht. Der Differenzverstärker $V_D$ kann sehr schnell arbeiten, so daß dieser für die Übertragung von Datensignalen s höherer Bitrate sehr gut geeignet ist. Wenn die Transistoren $T_{r1}$, $T_{r2}$ der beiden Emitterverstärker des Differenzverstärkers $V_D$ völlig identisch sind, wird der Differenzverstärker $V_D$ von der Umgebungstemperatur nicht beeinträchtigt, so daß der Ansteuerungsstrom $I_m$ der Laserdiode LD in der Form konstant bleibt. Das optische Datensignal $S_{opt}$ mit einem Tastverhältnis von 1:1 erzeugt eine niedrigste Bitfehlerhäufigkeit Diese steigt schnell an, wenn das Tastverhältnis von diesem Idealwert abweicht, bis zu einer Grenze, bei der eine einwandfreie Nachrichtenobertragung nicht mehr möglich ist. Das Tastverhältnis ist das Verhältnis eines Signales über einer Zeitachse, bezogen auf die mittlere Linie des Signales, d.h. die 50%-Linie. Das Tastverhältnis ist z.B. das zeitliche Verhältnis von H-Level zu L-Level oder H-Pegel zu L-Pegel oder das Verhältnis der Zeitlängen von positiver und negativer Halbwelle.

Die Laserdiode LD benotigt einen Vorstrom $I_{vor}$, der etwa so groß wie der Schwellstrom ist, bei dem die Laserdiode LD zu lasern beginnt, und einen Modulationsstrom $I_m$ der dem elektrischen Datensignal s proportional ist. Negen der starken Temperaturabhängigkeit ist es erforderlich, sowohl den Vorstrom $I_{vor}$ als auch den Modulationsstrom $I_m$ in ihrer Größe mit Hilfe der Photodiode PD derart zu regeln, daß die mittlere optische Sendeleistung $P_m$ und die Amplituden $P_s$ der optischen Impulse erhalten bleiben. Außerdem ist die Regelung des Modulationsstromes $I_m$ deswegen erforderlich, weil die Licht-Strom-Kennlinie (PI-Kennlinie) der Laserdiode LD durch sogenannte Alterungseffekte normalerweise flacher wird.

Der Differenzverstärker VD mit der idealen Eigenschaft würde zwei völlig identische Transistoren $T_{r1}$, $T_{r2}$ völlig identische Widerstände $R_1$, $R_2$, $R_3$ und $R_4$ für die Einstellung der Arbeitspunkte $U_{B1}$, $U_{B2}$ benötigen. Nur dann können die beiden Basisspannungen $U_{B1}$ und $U_{B2}$ und die beiden Ströme, die durch die Kollektorkreise der Transistoren $T_{r1}$, $T_{r2}$ fließen, gleich sein und von der Temperatur nicht beeinflußt werden. Im realen Falle sind die Spannungen $U_{B1}$ und $U_{B2}$ wegen der unterschiedlichen Eigenschaften der Transistoren $T_{r1}$, $T_{r2}$ und der Widerstände $R_1$, $R_2$, $R_3$ und $R_4$ ungleich, so daß sich das Tastverhältnis $T_1/T_2$ der optischen Impulsform mit der Temperatur ändert, obwohl die mittlere Sendeleistung $P_m$ durch die Regelung konstant gehalten werden kann. Die Folge ist, daß die Bitfehlerhäufigkeit schwankt oder ansteigt, z.B. mit der Temperatur oder der schwankenden Versorgungsspannung.

Mit der voranstehend beschriebenen bekannten Schaltungsanordnung eines optischen Senders für elektrische Datensignale wird erreicht, daß die mittlere Sendeleistung $P_m$ und die Amplituden $P_s$ der optischen Impulse konstant bleiben, jedoch ändert sich das Tastverhältnis $T_1/T_2$ des optischen Sendesignales. Mit der nachstehend beschriebenen, erfindungsgemäßen Schaltungsanordnung eines optischen Senders für elektrische Datensignale bleibt das Tastverhältnis $T_1/T_2$ des optischen Sendesignales konstant, wozu die Spannung $U_{B2}$ im Arbeitspunkt geregelt wird.

Die erfindungsgemäße Schaltungsanordnung umfaßt gemäß dem in Figur 2 dargestellten Blockschaltbild einen Differenzverstärker $V_D$ mit angeschlossener Laserdiode LD, einen Regler R, eine Spitzenwert-Erkennungsschaltung SES und eine Detektorschaltung DS mit angeschlossener Photodiode PD. Der Verstärker $V_D$ ist gemäß Fig. 3 in gleicher Weise wie der Verstärker $V_D$ der bekannten Schaltungsanordnung gemäß Fig. 1 aufgebaut. Entsprechendes gilt auch für die Detektorschaltung DS. Der wesentliche Unterschied der nunmehr beschriebenen erfindungsgemäßen Schaltungsanordnung eines optischen Senders für elektrische Datensignale besteht in der Zwischenschaltung der Spitzenwert-Erkennungsschaltung SES und des Reglers R, deren konkrete schaltungstechnische Ausgestaltung anhand der Fig. 4 näher erläutert wird.

Der Verstärker VD umfaßt einen Dateneingang für das Datensignal s, einen ersten Kondensator $C_6$, zwei zwischen einen Arbeitspunkt $U_{b1}$ und Erde bzw. der negativen Versorgungsspannung $V^-$ geschaltete Widerstände $R_1$ bzw. $R_2$, zwei Transistoren $T_{r1}$, $T_{r2}$, eine erste Stromquelle $S_1$ zur Einstellung des Modulationsstromes $I_m$, eine zweite Stromquelle $S_2$ zur Einstellung des Vorstromes $I_{vor}$ und eine Sendediode in Form einer Laserdiode LD, die zwischen dem Kollektor des Transistors $T_{r2}$

und Erde geschaltet ist. Auch der Kollektor des Transistors $Tr_1$ ist gegen Erde geschaltet. Die Emitter der Transistoren $Tr_1$, $Tr_2$ sind mit der Stromquelle $S_1$ zur Regelung des Modulationsstromes $I_m$ verbunden. Die Stromquellen $S_1$, $S_2$ sind über Leitungen $l_1$, $l_2$ mit der Detektorschaltung DS verbunden, an welche wiederum die Photodiode PD angeschlossen ist. Zwischen der Detektorschaltung DS und dem Arbeitspunkt $U_{B2}$ der Basis des Transistors $Tr_2$ des Differenzverstärkers $V_D$ ist eine Kettenschaltung aus der Spitzenwert-Erkennungsschaltung SES und dem Regler R eingeschaltet.

Die Spitzenwert-Erkennungsschaltung SES umfaßt einen ersten Verstärker $V_1$ und ein Differenzierglied mit dem Kondensator $C_2$ und dem Widerstand $R_{12}$ sowie zwei Spitzenwert-Detektoren $SWD_1$ und $SWD_2$. Zwischen der Detektorschaltung DS und dem nicht-invertierenden Eingang des ersten Verstärkers $V_1$ ist ein Kondensator $C_1$ eingeschaltet, mit welchem der Wechselanteil des mit Hilfe der Photodiode PD detektierten optischen Datensignals gekoppelt wird. Das gekoppelte Signal wird durch den Verstärker $V_1$ verstärkt, dessen Verstärkungsfaktor durch zwei in Reihe und gegen Erde geschaltete Widerstände $R_{13}$, $R_{14}$ gebildet wird, deren Mittelpunkt an den invertierenden Eingang des Verstärkers $V_1$ geschaltet ist. Der Ausgang des Verstärkers ist über einen Kondensator $C_2$ mit den Spitzenwert-Detektoren $SWD_1$, $SWD_2$ verbunden, wobei der Kondensator $C_2$ mit dem Widerstand $R_{12}$ das Differenzierglied bildet. Die beiden parallel geschalteten Spitzenwert-Detektoren $SWD_1$, $SWD_2$ bestehen jeweils aus einem gegen Erde geschalteten Kondensator $C_3$, $C_4$ und einem gegen Erde geschalteten Widerstand $R_{10}$, $R_{11}$ sowie einer Diode $D_1$, $D_2$, wobei die Diode $D_1$ mit ihrer Anode mit dem Kondensator $C_2$ und die Diode $D_2$ mit ihrer Kathode mit dem Kondensator $C_2$ verbunden sind. Die beiden Dioden $D_1$, $D_2$ sind insbesondere als Schottky-Dioden ausgebildet, die für das Arbeiten über einen großen Frequenzbereich geeignet sind.

Das durch den Kondensator $C_1$ gekoppelte und durch den ersten Verstärker $V_1$ verstärkte Signal wird mittels des Differenzergliedes und des Spitzenwert-Detektors $SWD_1$ in eine positive Spannung $U_p$ und mittels des Spitzenwert-Detektors $SWD_2$ in eine negative Spannung $U_n$ zerlegt. Die Differenz $\Delta U = U_p - U_n$ wird dem Regler R zugeführt. Dieser besteht aus dem zweiten Verstärker $V_2$, dessen invertierender Eingang über einen Widerstand $R_9$ an die Spitzenwert-Erkennungsschaltung SES angeschlossen ist. Der nicht-invertierende Eingang des Verstärkers $V_2$ ist über einen Widerstand $R_8$ an Erde geschaltet. Parallel zum invertierenden Eingang und zum Ausgang des Verstärkers $V_2$ ist ein Rückkopplungswiderstand $R_7$ geschaltet. Der Ausgang des Verstärkers $V_2$ ist über

einen Widerstand $R_5$ mit dem invertierenden Eingang eines I-Reglers IR verbunden, dessen nicht-invertierender Eingang über einen Widerstand $R_6$ an eine Referenzspannungsquelle $U_{ref}$ geschaltet ist. Ein Kondensator $C_5$ ist parallel zum invertierenden Eingang und zum Ausgang des I-Reglers IR geschaltet, der Ausgang des I-Reglers IR ist über den Arbeitspunkt $U_{b2}$ und einen Widerstand $R_b$ an die Basis des Transistors $Tr_2$ des Differenzverstärkers $V_D$ geschaltet. Der an den nicht-invertierenden Eingang des Verstärkers $V_2$ geschaltete Widerstand $R_8$ dient zur Kompensation der Offset-Spannung. Der zwischen den Ausgang des Verstärkers $V_2$ und den invertierenden Eingang des I-Reglers IR geschaltete Widerstand $R_5$ bildet zusammen mit dem Kondensator $C_5$ eine Integrationszeit für den I-Regler IR. Die Verstärkungsfaktoren der beiden Verstärker $V_1$ und $V_2$ werden wie folgt gebildet:

$$VF_{V_1} = 1 + \frac{R_{14}}{R_{13}}$$

$$VF_{V_2} = - \frac{R_7}{R_9}$$

Die Differenz der positiven Spannung $U_p$ und der negativen Spannung $U_n$, d.h. $\Delta U = U_p - U_n$ wird durch den Verstärker $V_2$ verstärkt und dem invertierenden Eingang des I-Reglers IR zugeführt. Mit Hilfe der Referenzspannung $U_{ref}$, die am nicht-invertierenden Eingang des I-Reglers IR anliegt, kann das erwünschte Tastverhältnis eingestellt werden. Des Ausgang des I-Reglers IR ist mit der Basis des Transistors $Tr_2$ über den Basiswiderstand $R_B$ verbunden, so daß der Regelkreis zwischen der Detektorschaltung DS und dem Differenzverstärker $V_D$ geschlossen ist.

Die Fig. 5 zeigt drei verschiedene Tastverhältnisse $T_1{:}T_2$ eines Datensignales s der Periodendauer T. Um das Tastverhältnis $T_1{:}T_2$ des optischen Sendesignales $S_{opt}$ konstant zu halten, wird erfindungsgemäß die Spannung im Arbeitspunkt $U_{B2}$ geregelt. Hierzu wird der Ist-Wert des Tastverhältnisses $T_1{:}T_2$ in der Spitzenwert-Erkennungsschaltung SES detektiert, indem der Wechselanteil des Sendeimpulses mittels der Photodiode PD detektiert und mit Hilfe der beiden Spitzenwert-Detektoren $SWD1$, $SWD_2$ in positive und negative Amplituden $U_p$ und $U_n$ zerlegt wird. Die Fig. 6 zeigt verschiedene prinzipielle Überlegungen für das Tastverhältnis. Wenn $|U_p|$ gleich $|U_n|$ ist, ist das Tastverhältnis $T_1{:}T_2$ gleich 1:1, d.h. $T_1$ ist gleich $T_2$. Wenn $|U_p|$ größer als $|U_n|$ ist, ist das Tastverhältnis kleiner als 1:1, d.h. $T_1$ ist kleiner als $T_2$. Wenn $|U_p|$ kleiner als $|U_n|$ ist, ist das Tastverhältnis größer als 1:1, d.h. $T_1$ ist größer als $T_2$. Mit der erfindungsgemäßen Schaltungsanordnung für einen optischen Sender kann unter Zuhilfenahme der Differenz $\Delta U = U_p - U_n$ die Spannung im Arbeits-

punkt $U_{B2}$ über den Regelkreis R so geregelt werden, daß das Tastverhältnis $T_1{:}T_2$ immer einen konstanten Wert hat, z.B. $T_1/T_2 = 1{:}1$.

**Ansprüche**

1. Optischer Sender für elektrische Datensignale, aus einer Sendediode, insbesondere Laserdiode oder lichtemittierende Diode, mit einer Vorstromquelle, aus einem zwei Emitterverstärker und eine Modulationsstromquelle umfassenden Differenzverstärker und aus einer eine Photodiode umfassenden Detektorschaltung zur Regelung des Vorstromes und des dem elektrischen Datensignal proportionalen Modulationsstromes in Abhängigkeit von den, von der Photodiode empfangenen optischen Impulsen der Sendediode,
**dadurch gekennzeichnet,**
daß zwischen der Detektorschaltung (DS) und dem Differenzverstärker ($V_D$) eine Spitzenwerterkennungsschaltung (SES) und ein Regler (R) eingeschaltet sind und daß das Tastverhältnis ($T_1/T_2$) des optischen Sendesignales ($S_{opt}$) der Sendediode (LD) in Abhängigkeit von den mittels der Spitzenwert-Erkennungsschaltung (SES) ermittelten Spitzenwerten ($U_p$, $U_n$) der positiven und negativen Amplituden mittels des Reglers (R) konstant gehalten wird.

2. Optischer Sender nach Anspruch 1,
**dadurch gekennzeichnet,**
daß die Spitzenwert-Erkennungschaltung (SES) aus einem Verstärker ($V_1$), einem einen Kondensator ($C_2$) und einen Widerstand ($R_{12}$) umfassenden Differenzierglied und zwei Spitzenwert-Detektoren ($SWD_1$, $SWD_2$) gebildet ist, die jeweils aus einer Diode ($D_1$, $D_2$), einem Widerstand ($R_{10}$, $R_{11}$) und einem Kondensator ($C_3$, $C_4$) bestehen, wobei die Dioden entgegengesetzt geschaltet sind und der Spitzenwert-Detektor ($SWD_1$) die positive Amplitude ($U_p$) und der Spitzenwert-Detektor ($SWD_2$) die negative Amplitude ($U_n$) des optischen Sendesignales ($S_{opt}$) ermittelt und das ermittelte Differenzsignal ($\Delta U = U_p - U_n$) über den Regler R an die Basis ($U_{B2}$) des Transistors ($Tr_2$) des Differenzverstärkers (VD) gegeben wird.

3. Optischer Sender nach Anspruch 1 oder 2,
**dadurch gekennzeichnet,**
daß der Regler (R) aus einem Verstärker ($V_2$) und einem I-Regler (IR) gebildet ist, welcher die Spannung am Arbeitspunkt ($U_{B2}$) in Abhängigkeit der Differenz ($\Delta U$) so regelt, daß das Tastverhältnis (T) immer einen konstant Wert hat.

# FIG.1

# FIG.2

# FIG.3

# FIG.4

V_D       R       SES       DS

# FIG.5

$T_1/T_2 = 100\%$      $T_1/T_2 > 100\%$      $T_1/T_2 < 100\%$

# FIG.6

$|U_p| = |U_n|$
für $T_1/T_2 = 100\%$

$|U_p| > |U_n|$
für $T_1 < T_2$

$|U_p| < |U_n|$
für $T_1 > T_2$

7